# EUROPEAN PATENT APPLICATION

(11) **EP 1 734 801 A1**
(43) Date of publication of application: **20.12.2006**
(21) Application number: 05793130.5
(22) Date of filing: 12.10.2005
(51) Int. Cl.: H05K 3/34, H05K 1/18, H01L 23/12, B23K 35/363

(54) **PACKAGING METHOD OF ELECTRONIC COMPONENT**

(30) Priority: 12.10.2004 JP 2004297426
(71) Applicant: Matsushita Electric Industries Co., Ltd., Kadoma-shi, Osaka 571-8501 (JP)
(72) Inventor: WADA, Yoshiyuki, Matsushita Electic Ind. Co., Chuo-ku, Osaka-shi, Osaka 540-6319 (JP); SAKAI, Tadahiko, Matsushita Electic Ind. Co., Chuo-ku, Osaka-shi, Osaka 540-6319 (JP)
(74) Representative: Pautex Schneider, Nicole Véronique
(86) International application number: PCT/JP2005/018743
(87) International publication number: WO 2006/041068

(57) **Abstract**

A method of packaging an electronic component, which is capable of enhancing electrical and mechanical bonding reliability of the electronic component. Terminal (4) is provided on the side face of electronic component (1). Electrode (6) is formed on one or the other major surface of substrate (5) and terminal (4) provided in electronic component (1) is located on electrode (6). Solder paste produced by mixing solder particles with thermosetting flux is applied to electrode (6), terminal (4) of electronic component (1) is mounted on and brought into contact with the applied solder paste, and electronic component (1) is mounted on substrate (5) with clearance (S) provided between a part of electronic component (1) and opposing substrate (5). Solder bonding structure (8) for coupling terminal (4) and electrode (6) is formed by reflow. Solder bonding structure (8) includes solder bonding portion (8a), resin reinforcing portion (8b) and resin adhering portion (8c). Resin reinforcing portion (8b) reinforces solder bonding portion (8a), and resin adhering portion (8c) fixes electronic component (1) to substrate (5) when the resin entering clearance (S) between electronic component (1) and substrate (5) is solidified.

## Description

### TECHNICAL FIELD

The present invention relates to a method of packaging an electronic component by solder bonding a terminal provided on the side face of the electronic component to an electrode formed on a substrate on which the electronic component is to be packaged.

### BACKGROUND ART

As a kind of an electronic component having a structure in which a semiconductor element is packaged on a small-sized substrate such as a ceramic package, a leadless electronic component is well known. The leadless electronic component is directly provided with an electric coupling terminal on the side face of the ceramic package without providing an external coupling lead. In the electronic component having such a structure, an external coupling electrode of, for example, a semiconductor element to be packaged on the ceramic package is electrically coupled to a terminal provided on the side face by a wiring circuit formed inside the ceramic package.

When a leadless electronic component is packaged on a substrate, for example, by solder bonding an electric coupling terminal provided on the side face of a ceramic package to an electrode provided on a substrate, the ceramic package is fixed to the substrate and at the same time, a coupling electrode is allowed to conduct a circuit electrode on the substrate. At this time, since a portion bonded by soldering, that is, a solder bonding portion is formed on the side face of the electronic component and the electrode on the substrate, it is difficult to secure electrical and mechanical reliability of the solder bonding portion. Therefore, a configuration in which a solder bonding portion is reinforced with resin adhesives is employed in many cases (see, for example, Japanese Patent Unexamined Publication No. 2004-146433).

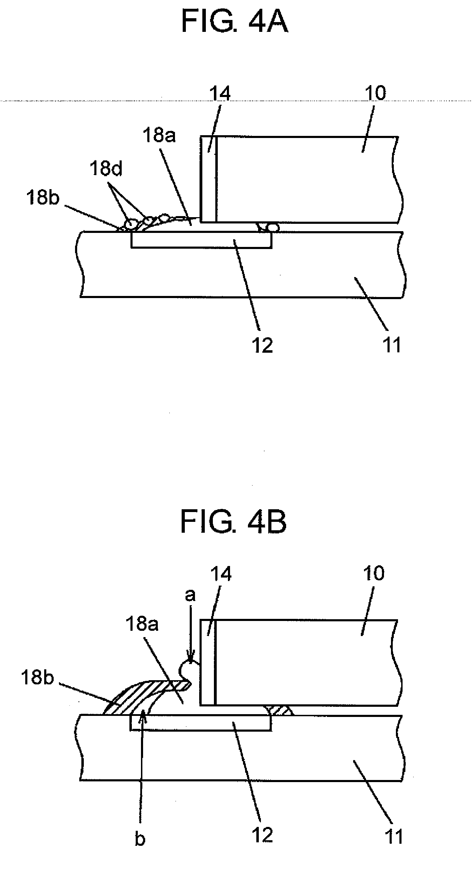

Fig. 4A shows a part of a conventional electronic component. Fig. 4A shows a solder bonding structure in which terminal 14 provided on the side face of electronic component 10 is solder bonded to electrode 12 on substrate 11 by using solder paste produced by mixing Sn-Bi lead-free solder particles with conventional thermosetting flux containing no plasticizer.

In the solder bonding structure shown herein, due to the property of Sn-Bi lead-free solder, it is difficult to form solder fillet having a desired shape and a sufficient bonding strength cannot be often secured. That is to say, the most part of solder supplied for coupling electrode 12 and terminal 14 makes solder balls 18d and is scattered together with a flux component during reflow. Consequently, a sufficient amount of solder cannot be secured for solder bonding portion 18a, so that the solder bonding portion tends to have an irregular shape.

Fig. 4B shows a conventional solder bonding structure and particularly shows a solder bonding structure using solder paste produced by mixing a plasticizer into thermosetting flux. Fig. 4B particularly shows a failure state occurring when the relative relation between a softening starting temperature of the plasticizer and a liquidus temperature of the solder is inappropriate. In a process of manufacturing a packaged substrate by packaging a large number of electronic components on a substrate, a solder bonding portion (for example, a component at the side of a first surface in a double- packaged substrate) that has already been solder bonded is heated again by reflow for solder bonding another components.

Under such circumstances, solder bonding portion 18a, which has once been solidified, is heated beyond a liquidus temperature and melted again to be fluidized. At this time, resin reinforcing portion 18b formed to cover solder bonding portion 18a is also heated. When the softening starting temperature of the plasticizer is higher than the liquidus temperature of the solder, since the plasticizer remains a solid state at the time when the solder is melted, resin reinforcing portion 18b is not softened, which prevents the free expansion of a melted solder of solder bonding portion 18a. Therefore, the melted solder flows outward from a clearance between resin reinforcing portion 18b and terminal 14 and is protruded (see arrow "a"). Due to the outflow of the solder, void (see arrow "b") is generated inside the resin reinforcing portion. Thus, solder bonding portion 18a comes to have an abnormal shape. Note here that the same reference numerals are given in Fig. 4B as the same places in Fig. 4A.

Furthermore, although not shown in Figs. 4A and 4B, a packaging method in which a solder bonding portion is reinforced with resin adhesives needs a special step of applying resin by using a dispenser for supplying a substrate or an electronic component with resin adhesives. Furthermore, as a manufacturing process becomes more complicated and electronic components to be mounted become finer and smaller, it is difficult to secure space for supplying resin adhesives.

### SUMMARY OF THE INVENTION

An object of the present invention is to provide a method of packaging an electronic component, which can enhance electrical and mechanical bonding reliability of a bonding terminal in the electronic component.

A method of packaging an electronic component of the present invention is a method of packaging an electronic component having a terminal on a side face thereof on an electrode on a substrate by solder bonding. The method includes a solder paste printing step of applying solder paste produced by mixing solder particles with thermosetting flux to the electrode provided on the substrate. Then, a terminal provided on the electronic component is brought into contact with the solder paste applied to the electrode provided on the substrate. Furthermore, the method includes an electronic component mounting step of mounting the electronic component on the substrate with a clearance provided between a part of the electronic component and the opposing substrate. In addition, the method includes a heating step of heating the substrate so as to melt solder in the solder paste and to fluidize the thermosetting flux in the solder paste for entering the clearance, followed by thermally being cured.

According to the present invention, the solder paste produced by mixing solder particles with thermosetting flux is applied to the electrode provided on the substrate and the terminal of the electronic component is brought into contact with the applied solder paste. The electronic component is mounted on the substrate with a clearance provided between a part of the electronic component and the opposing substrate, followed by carrying out reflow. Thereby, solder in the solder paste is allowed to melt. Thermosetting flux in the solder paste is fluidized so as to enter the clearance, followed by being thermally cured. Then, the electronic component is reinforced with the thermally cured resin and thus electrical and mechanical bonding reliability of the electronic component can be enhanced.

### BRIEF DESCRIPTION OF THE DRAWINGS

Fig. 1 is a perspective view showing an electronic component completed by a method of packaging an electronic component in accordance with an exemplary embodiment of the present invention.
Fig. 2A is a view showing a step of forming an electrode on a substrate in accordance with an exemplary embodiment of the present invention.
Fig. 2B is a view showing a step of applying paste on the electrode provided on the substrate in accordance with the exemplary embodiment of the present invention.
Fig. 2C is a view showing a step of mounting the electronic component on the substrate in accordance with the exemplary embodiment of the present invention.
Fig. 2D is a view showing a step of reflow of solder paste in accordance with the exemplary embodiment of the present invention.
Fig. 3 is a partial cross-sectional view showing a packaged structure of the electronic component in accordance with the exemplary embodiment of the present invention.
Fig. 4A is a view to illustrate a solder bonding method using a conventional solder paste.
Fig. 4B is a view to illustrate another solder bonding method using a conventional solder paste.

### REFERENCE MARKS IN THE DRAWINGS

- 1: electronic component
- 2: package substrate
- 3: semiconductor element
- 4: terminal
- 5: substrate
- 6: electrode
- 7: solder paste
- 8: solder bonding structure
- 8a: solder bonding portion
- 8b: resin reinforcing portion
- 8c: resin adhering portion
- S: clearance

### DETAILED DESCRIPTION OF THE PREFERRED EMBODIMENTS

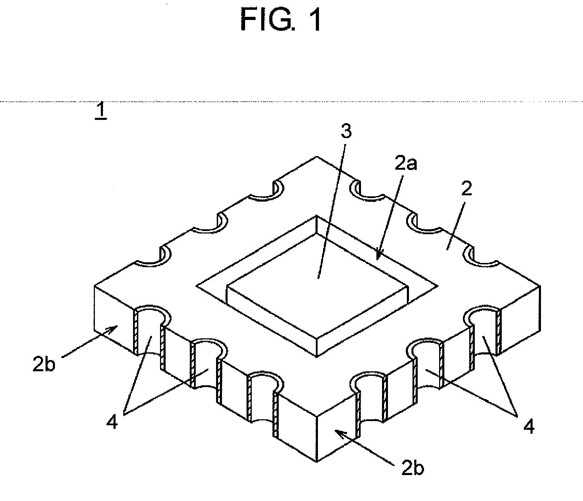

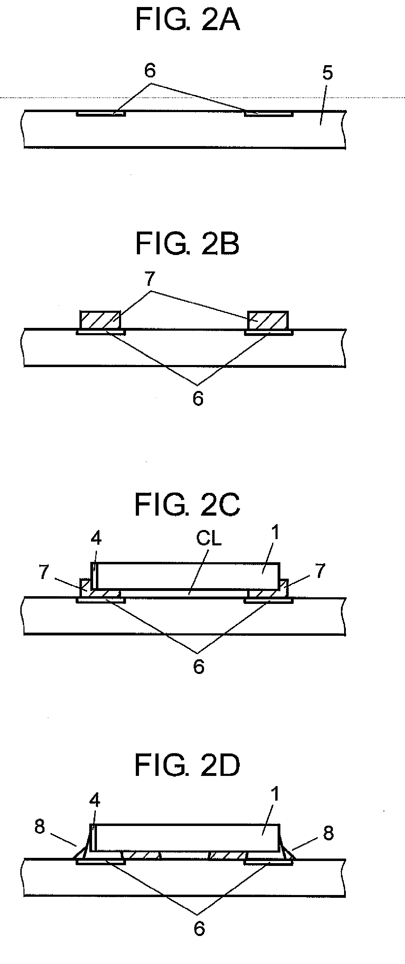

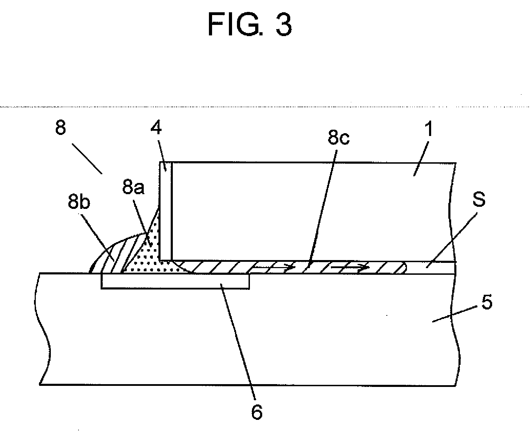

The exemplary embodiment of the present invention is described with reference to drawings. Fig. 1 is a perspective view showing an electronic component completed by a method of packaging an electronic component in accordance with an exemplary embodiment of the present invention. Figs. 2A to 2D are views showing steps of the method of packaging the electronic component. Fig. 3 is a partial sectional view showing a packaged structure of the electronic component.

Firstly, with reference to Fig. 1, a structure of the electronic component completed by the method of packaging an electronic component in accordance with the present invention is described. Electronic component 1 includes, for example, ceramic package substrate 2 having recess 2a formed in substantially the middle portion. Semiconductor element 3 is packaged in recess 2a. On side face 2b of package substrate 2, external coupling terminal 4 is formed.

Terminal 4 is formed by providing a through hole extending from one major surface (the other major surface) through the other major surface (one major surface) in package substrate 2 in a state before it is divided into small pieces and plating the inner surface of the through hole with conductive metal. A wiring circuit (not shown) arranged in package substrate 2 is coupled to an external coupling electrode (not shown) provided in semiconductor element 3. When electronic component 1 is packaged on a substrate, by solder bonding terminal 4 to an electrode formed on the substrate, a main body of package substrate 2 is fixed to the substrate and terminal 4 is allowed to conduct the electrode provided on the substrate.

Next, with reference to Figs. 2A to 2D, a method of packaging electronic component 1 on the substrate is described. As shown in Fig. 2A, electrode 6 is formed on at least one of one major surface and the other major surface of substrate 5. On the upper surface of electrode 6, as shown in Fig. 2B, solder paste 7 is applied by, for example, a screen printing method (solder paste applying step).

Herein, solder paste 7 used for packaging electronic component 1 on substrate 5 by solder bonding is described. Solder paste 7 has a composition including a metal component containing solder particles, solid resin as thermosetting resin and a plasticizer, and thermosetting flux having an active effect in order to remove a solder oxide film. The solid resin is a so-called thermoplastic resin having a property of being a solid at ordinary temperature and changing its state into liquid when it is heated. As solder, solder without containing a lead component, that is, lead-free solder is employed. Depending upon the properties of a substrate to be packaged and an electronic component, two kinds of solders are selected.

For an electronic component that can be subjected to heat treatment up to relatively high temperature, Sn (tin)-Ag (silver)-Cu (copper) solder (liquidus temperature: 220°C) is employed. For an electronic component whose heat treatment temperature is desired to be extremely low, Sn (tin)-Bi (bismuth) solder (liquidus temperature: 139°C) is employed. Sn-Bi solder can enhance the solder bonding strength by adjusting the mixing ratio of Ag (silver) to 1 wt% to 3 wt%. Then, such a solder contains particles in the solder paste in the mixing ratio ranging from 70 wt% to 92 wt%.

As the metal component, other than solder particles, metal powder obtained by making a metal such as Ag (silver), palladium (Pd), and Au (gold) into foils is mixed in the mixing ratio of 0.5 wt% to 10 wt%. Thereby, a solder bonding property can be further enhanced. Since the above-mentioned metals have a melting point higher than that of the solder to be used, it is possible to prevent an oxide film from being formed in the atmosphere. Furthermore, since fluidized solder in which solder particles are melted has a property of being easily wet along the surface, the advantage of improving the solder wettability is exhibited when the melted solder aggregates around the above-mentioned metal powder as a nucleus in a solder bonding process by reflow.

Furthermore, the solid resin is prepared so that the liquidus temperature of solder is not lower than the softening temperature of the solid resin. With such a configuration, as mentioned below, the following advantage is obtained: the degree at which flowing of melted solder is prevented by a resin component in solder paste 7 during reflow is reduced and thus excellent solder bonding can be carried out.

As shown in Fig. 2C, electronic component 1 is mounted on substrate 5. Terminal 4 provided on a part (side face) of electronic component 1 is positioned to electrode 6, and the end portion of electronic component 1 is brought into contact with solder paste 7. Thus, electronic component 1 is temporally fixed by the adhesion of solder paste 7. At this time, electronic component 1 is mounted on substrate 5 while adjusting a predetermined position and height so that clearance S having a predetermined dimension (5 to 200 µm) is provided between a part (a lower part in Fig. 2C) of electronic component 1 and one surface of opposing substrate 5.

Then, as shown in Fig. 2D, substrate 5 on which electronic component 1 is mounted is carried in a reflow device and solder contained in solder paste 7 is heated to the liquidus temperature or higher. With this heating treatment, the solder contained in solder paste 7 is melted and the melted solder adheres to terminal 4. At this time, curing of thermosetting resin contained in solder paste 7 is promoted. In addition, the plasticizer contained in the thermosetting resin is changed to liquid.

Fig. 3 shows a state in which electrode 6 from which an oxide film is removed by a flux component contained in solder paste 7 during heat treatment shown in Fig. 2D and terminal 4 are wetted by the melted solder. As shown in Fig. 3, electrode 6 and terminal 4 are coupled to each other with fillet-shaped melted solder. Furthermore, the thermosetting resin contained in solder paste 7 is once softened due to the temperature rise and its viscosity is lowered. The thermosetting resin is fluidized together with a liquidized plasticizer. Then, the fluidized resin components work so as to cover solder bonding portion 8a and electrode 6 from the side of the upper surface. A part of the resin component enters clearance S between electronic component 1 and substrate 5 by the capillary phenomenon. During these processes, thermal curing of the thermosetting resin in solder paste 7 proceeds simultaneously.

Then, substrate 5 is taken out from the reflow device and returned it to ordinary temperature. At this time, the plasticizer contained in solder paste 7 and the melted solder are solidified. Thus, the melted solder is solidified so as to form fillet-shaped solder bonding portion 8a for coupling electrode 6 and terminal 4. Furthermore, when the resin component covering solder bonding portion 8a and electrode 6 from the side of the upper surface is solidified, resin reinforcing portion 8b for reinforcing solder bonding portion 8a is formed. In addition, when the resin component entering clearance S between electronic component 1 and substrate 5 is solidified, resin adhering portion 8c that fixes electronic component 1 to electrode 6 is formed. Consequently, solder bonding structure 8 is produced by solder bonding terminal 4 of electronic component 1 to electrode 6 on substrate 5 by using paste 7.

When the solid resin in the thermosetting flux contained in solder paste 7 is changed to liquid at the time when solder is melted, the thermosetting flux maintains the original state without losing the flowing property even when it is heated to a temperature at which solder is melted. Therefore, the self-alignment phenomenon of the melted solder is not prevented. After this solder bonding process is completed, thermal curing of the thermosetting resin of the thermosetting flux is completed. In addition, a plasticizer, which has been once liquidized by heat treatment, is solidified again to become a complete solid state when it is cooled to ordinary temperature. At this time, resin reinforcing portion 8b that reinforces by covering solder bonding portion 8a on the upper surface of electrode 6 and resin adhering portion 8c for fixing electronic component 1 to substrate 5 are formed.

The above-mentioned method of packaging an electronic component is a method of packaging electronic component 1 having terminal 4 on the side face thereof on electrode 6 provided on one major surface of substrate 5 by solder bonding. The method includes a solder paste applying step of applying solder paste 7 produced by mixing solder particles with thermosetting flux to electrode 6 on substrate 5. Furthermore, the method includes an electronic component mounting step of bringing terminal 4 of electronic component 1 into contact with solder paste 7 applied to electrode 6 and then mounting electronic component 1 on substrate 5 with clearance S provided between a part of electronic component 1 and opposing substrate 5. The method includes heating step of heating substrate 5 so as to melt solder in solder paste 7 and to fluidize thermosetting flux in solder paste 7 for entering clearance S, followed by being thermally cured.

By employing such a method of packaging an electronic component, as in the case where leadless electronic component 1 is packaged on substrate 5, an electronic component having a terminal on the side face thereof is packaged on the substrate by solder bonding. In the method, when the terminal on the side face is solder bonded to the electrode on the substrate, there has conventionally been a difficulty in forming a solder bonding portion having a sufficient amount of solder. Therefore, an additional step of carrying out reinforcing treatment by a method such as resin sealing has been needed after the solder bonding step.

On the contrary, in this exemplary embodiment, at the same time when solder bonding is carried out, a resin reinforcing portion is formed. The resin reinforcing portion reinforces a solder bonding portion by covering the solder bonding portion with a resin component in solder paste. Therefore, a resin adhering portion that fixes an electronic component main body directly to a substrate is formed by a cured resin component.

Furthermore, when fine and small electronic components are packaged on the substrate, it is difficult to secure sufficient space for supplying reinforcing resin. However, since these resin components are contained in the solder paste, at the time of applying solder paste for supplying solder, a resin component can be supplied together. Therefore, even when fine and small electronic components, in which it has been conventionally difficult to electrically and mechanically reinforce a solder bonding portion, are packaged, by using the method of mounting an electronic component of the present invention, electrical and mechanical reliability of a terminal bonding portion provided in an electronic component can be considerably improved.

Then, in the above-mentioned heating process, resin reinforcing portion 8b is formed so that thermosetting flux containing fluidized thermosetting resin and a plasticizer covers the surface of electrode 6, which is not covered with melted solder, that is, a portion that is so-called AKAME (Red-eye). Thus, a portion of electrode 6, which is not covered with solder bonding portion 8a, can be covered with resin reinforcing portion 8b. This can prevent electrode 6 from being exposed and oxidized after solder bonding. Therefore, a resin coating treatment, which was conventionally necessary for preventing oxidization, can be excluded. Thus, the process can be simplified and the cost can be reduced.

Furthermore, use of solder paste 7 for packaging electronic component 1 can prevent coupling deficiency, which tends to occur when similar electronic component 10 is solder bonded by using a conventional solder paste.

Also in such an example of solder bonding, as described in the present invention, by using solder paste having a composition containing a plasticizer in thermosetting flux, the following advantage can be exhibited. That is to say, although curing of the thermosetting resin by the heating treatment in reflow deteriorates the flowing property of a flux component. However, since liquefaction of the plasticizer by the heating treatment proceeds simultaneously, the deterioration of the flowing property of the flux component can be compensated by the liquefaction of the plasticizer. This can avoid the inhibition of aggregation of the melted solder by the flux component in reflow and enables aggregation of the melted solder. Thus, a solder bonding portion having a desired shape can be formed.

Furthermore, after reflow, a resin reinforcing portion produced by solidifying a compatible state of thermally cured thermosetting resin and a plasticizer that is cooled to be solidified is formed so as to cover the solder bonding portion. Therefore, even when lead-free solder having a low melting point, which is fragile and poor in bonding strength, is used, the solder bonding portion can be reinforced by the resin reinforcing portion. Thus, the bonding reliability can be secured.

Herein, a detailed example of the component composition of solder paste 7 is described. Solder paste 7 has a structure in which solder particles are mixed into thermosetting flux as mentioned above. The thermosetting flux of this exemplary embodiment has a basic composition including a base containing epoxy as a component, a curing agent for thermally curing this base and a curing accelerator, an active material for removing an oxide film of solder, a plasticizer including thermoplastic solid resin, and a solvent.

Next, kinds and mixing ratio of the components of the above-mentioned basic composition are described. The composition includes hydrogenated bisphenol A epoxy resin (30 wt% to 40 wt%) as the base, methyl tetrahydrophthalic anhydride (30 wt% to 40 wt%) as the curing agent, 2-phenyl-4-methyl-5-hydroxymethylimidazole (1 wt% to 2 wt%) as the curing accelerator, m-hydroxybenzoic acid (3 wt% to 10 wt%) as the active material, alkylphenol denatured xylene resin (3 wt% to 20 wt%) as the plasticizer, and butyl carbitol (0 wt% to 5 wt%) as the solvent, respectively.

Note here that for the above-mentioned respective components, the following materials can be selected as alternatives. Firstly, as the base of thermosetting flux, 3,4-epoxycyclohexenyl methyl-3,4-epoxycyclohexene carboxylate, bisphenol F epoxy resin or bisphenol A epoxy resin can be selected instead of hydrogenated bisphenol A epoxy resin. Furthermore, as the curing agent, methyl hexahydrophtalic anhydride can be selected instead of methyl tetrahydrophthalic anhydride. As the curing accelerator, 2-phenyl-4,5-dihydroxymethylimidazole can be selected instead of 2-phenyl-4-methyl-5-hydroxymethylimidazole.

Then, as the active material, mesaconic acid can be selected instead of m-hydroxybenzoic acid; as the plasticizer, fatty acid amide or high polymerization rosin can be selected instead of alkylphenol denatured xylene resin; and as the solvent, methyl carbitol can be selected instead of butyl carbitol. The mixing ratios of the above-mentioned respective components are the same as the values shown in the basic mixing example mentioned above. Furthermore, since acid anhydride itself used as the curing agent has an active effect of removing an oxide film, an active material may not be mixed.

As the thermosetting resin, the base can be selected from a material including at least one of acryl, urethane, phenol, urea, melamine, unsaturated polyester, amine, and silicon, in addition to epoxy resin. A solid resin used as the plasticizer, which is selected from terpene resin, phenolic resin, xylene resin, urea resin, melanin resin, amorphous rosin, imido resin, olefin resin, acrylic resin, amide resin, polyester resin, styrene, polyimide, and fatty acid derivative, is mixed into the thermosetting resin.

When a solid resin having compatibility with respect to the base in terms of a component of the base is selected in the selection of the above-mentioned solid resin, when the solid resin is mixed into the base, it is possible to realize liquid resin having a flowing property without using a solvent containing a vaporizing gas component. Thus, it is possible to reduce environmental load due to use of a solvent, for example, attachment of gas component by gas vaporized from the solvent to the inside of a reflow device, pollution of working environment in a factory, and the like.

Furthermore, by using Sn-Bi solder, that is, lead-free solder having a low melting point, the following excellent advantages can be exhibited. That is to say, recently, from the viewpoint of the demand of environmental protection, use of lead-free solder has been mainstream in electronic equipment manufacturing industry. The generally used Sn-Ag-Cu solder has a liquidus temperature of 220°C. Since such a solder has a liquidus temperature higher than that of SnPb eutectic solder that has mainly been used conventionally, it has been difficult to apply such a solder dependent upon the subjected substrates and components.

On the contrary, since Sn-Bi solder has a liquidus temperature of 139°C, such a solder is desired to be used for components (for example, a CCD element, aluminum electrolytic capacitor, and the like) having a low heat resistance. However, Sn-Bi solder has a strength property of being mechanically fragile. Furthermore, as mentioned above, since there is difficulty in forming a solder bonding portion having a desired shape in reflow and there is disadvantage in electrical and mechanical reliability in solder bonding, such a solder has been used in a limited range.

In this exemplary embodiment, Sn-Bi solder having such a property is used as solder paste produced by mixing a plasticizer with thermosetting flux. Thus, the application range can be substantially increased. By employing such solder paste 7, the deterioration of the flowing property of the flux component due to curing of the thermosetting resin in reflow can be compensated by the liquefaction of the plasticizer as mentioned above.

Thus, the degree at which aggregation of melted solder is inhibited by the flux component is reduced and a solder bonding portion having a desired shape can be formed. Furthermore, since the formed solder bonding portion is reinforced by being covered with the resin reinforcing portion including the cured thermosetting resin and the solidified plasticizer, shortage of strength of the solder bonding portion derived from the strength property of Sn-Bi solder can be compensated by the resin reinforcing portion. Thus, electrical and mechanical reliability of the solder bonding portion can be further enhanced.

In this way, by securing a bonding process capable of putting lead-free Sn-Bi solder having a low melting point to practical use, the application can be expanded to substrates and components having low heat-resistant temperature as mentioned above. In addition, the secondary effect that a heat temperature can be lowered, that is, the number of preheating stages can be reduced enables miniaturization of a reflow device and reduction in power consumption.

There is an upper limit to temperature for heating an electronic component. High-cost bonding processes conventionally employed when solder bonding is required to be carried out at a low temperature, for example, a method using Ag paste produced by mixing silver powder into resin adhesives, an individual bonding process for carrying out solder bonding by locally heating a substrate with a laser, soft beam, and the like, without heating the entire substrate, are not required to be employed. Therefore, expensive materials and devices come to be unnecessary and the manufacturing cost can be reduced.

Furthermore, a low thermal resistance material, for example, cheap material such as paper phenol can be used for a substrate. Such a material has not been able to be used conventionally because the liquidus temperature is substantially lower than the liquidus temperature (183°C) of conventional SnPb eutectic solder. Expensive substrate materials such as BT resin are not necessary, and thus the material cost can be reduced.

As solder paste 7 containing the above-mentioned lead-free solder, the following component composition is recommended. Firstly, when Sn-Ag-Cu solder (liquidus temperature: 220°C) is used, a component composition including hydrogenated bisphenol A epoxy resin (38 wt%) as a base, methyl tetrahydrophthalic anhydride (38 wt%) as a curing agent, 2-phenyl-4-methyl-5-hydroxymethylimidazole (1 wt%) as a curing accelerator, m-hydroxybenzoic acid (10 wt%) as an active material, and high polymerization rosin (13 wt%) as a plasticizer is used. In this example, the softening temperature of the plasticizer is 140°C. This example is selected so that the liquidus temperature of the solder is higher than the softening temperature of the plasticizer.

Next, when Sn-Bi solder (liquidus temperature: 139°C) is used, a component composition including hydrogenated bisphenol A epoxy resin (38 wt%) as a base, methyl tetrahydrophthalic anhydride (38 wt%) as a curing agent, 2-phenyl-4-methyl-5-hydroxymethylimidazole (1 wt%) as a curing accelerator, m-hydroxybenzoic acid (10 wt%) as an active material, and an alkylphenol denatured xylene resin (13 wt%) as a plasticizer is used. In this example, the softening temperature of the plasticizer is 120°C. This example is selected so that the liquidus temperature of the solder is higher than the softening temperature of the plasticizer as in the above example.

In this exemplary embodiment, as shown in the above-mentioned example of the component composition, the kind of solder and combination of components of the thermosetting flux are set so that the liquidus temperature of the solder is higher than the softening temperature of the plasticizer. Thus, when the solder is melted, the resin reinforcing portion can be softened by the plasticizer that has started to be softened. Therefore, it is possible to prevent the above-mentioned problems arisen when the resin reinforcing portion prevents the free expansion of the melted solder.

As mentioned above, in the method of packaging an electronic component shown in this exemplary embodiment, in the packaging of an electronic component, for example, a leadless type electronic component, in which electronic component 1 having terminal 4 on the side face thereof is soldered to electrode 6 on substrate 5, solder paste 7 produced by mixing solder particles with thermosetting flux is applied to electrode 6 on substrate 5 and terminal 4 is brought into contact with the applied solder paste 7. Then, electronic component 1 is mounted on substrate 5 with clearance S provided between the lower surface of electronic component 1 and the upper surface of substrate 5, followed by carrying out reflow. Thus, resin is obtained by melting solder in solder paste 7 and fluidizing thermosetting resin in solder paste 7 for entering clearance S, followed by being thermally cured. With this resin, the bonding reliability can be enhanced.

### INDUSTRIAL APPLICABILITY

A method of packaging an electronic component in accordance with the present invention has an advantage that coupling reliability can be enhanced and is useful for applications for packaging an electronic component, for example, a leadless electronic component, which has an external coupling terminal on the side face thereof on a substrate by solder bonding. Therefore, the method of the present invention is industrially applicable.

## Claims

1. A method of packaging an electronic component for packaging an electronic component having a terminal on a side face thereof on an electrode on a substrate by solder bonding, the method comprising
applying solder paste produced by mixing solder particles with thermosetting flux to the electrode on the substrate;
bringing the terminal of the electronic component into contact with the solder paste applied to the electrode and mounting the electronic component on the substrate with a clearance provided between a part of the electronic component and the substrate; and
heating the substrate so as to melt solder in the solder paste and to fluidize the thermosetting flux in the solder paste for entering the clearance, followed by being thermally cured.

2. The method of packaging an electronic component of claim 1, wherein in the heating, the fluidized thermosetting flux covers a portion that is not covered with the melted solder on a surface of the electrode.

3. The method of packaging an electronic component of claim 1, wherein the solder paste comprises solid resin having a property of being solid at ordinary temperature and being changed to liquid by heating.
